# EUROPÄISCHE PATENTSCHRIFT

(11) **EP 1 644 995 B1**
(45) Veröffentlichungstag und Bekanntmachung des Hinweises auf die Patenterteilung: **16.04.2008**
(21) Anmeldenummer: 04762375.6
(22) Anmeldetag: 12.07.2004
(51) Int. Cl.: H01L 51/40, C09K 11/06, C23C 18/18, C03C 17/38

(54) **HALBLEITERBAUELEMENT UND VERFAHREN ZU DESSEN HERSTELLUNG**
SEMICONDUCTOR COMPONENT, AND METHOD FOR THE PRODUCTION THEREOF
COMPOSANT EN SEMI-CONDUCTEUR, ET SON PROCEDE DE PRODUCTION

(30) Priorität: 11.07.2003 DE 10332567
(43) Veröffentlichungstag der Anmeldung: 12.04.2006
(73) Patentinhaber: Qimonda AG, 81739 München (DE)
(72) Erfinder: HALIK, Marcus, D-91058 Erlangen (DE); KLAUK, Hagen, Dr., D-70195 Stuttgart (DE); SCHMID, Günter, D-91334 Hemhofen (DE); ZSCHIESCHANG, Ute, D-70195 Stuttgart (DE)
(74) Vertreter: Gross, Felix
(86) Internationale Anmeldenummer: PCT/DE2004/001515
(87) Internationale Veröffentlichungsnummer: WO 2005/008803

(56) Entgegenhaltungen:
- EP-A- 1 179 863
- WO-A-96/07487
- DE-A- 10 025 522
- DE-A- 19 815 220
- PATENT ABSTRACTS OF JAPAN Bd. 0135, Nr. 75 (C-667), 19. Dezember 1989 (1989-12-19) & JP 1 240598 A (NEC CORP), 26. September 1989 (1989-09-26)

## Beschreibung

Die Erfindung betrifft ein Halbleiterbauelement nach dem Oberbegriff des Anspruchs 1 und ein Verfahren zur Herstellung einer Schicht auf einem Substrat nach dem Oberbegriff des Anspruchs 12.

Organische Feldeffekttransistoren (OFETs) auf der Basis organischer Halbleiterschichten sind von Interesse für eine Vielzahl elektronischer Anwendungen, die niedrige Fertigungskosten, flexible oder unzerbrechliche Substrate, oder die Herstellung von Transistoren und integrierten Schaltungen über große aktive Flächen erfordern. Zum Beispiel eignen sich organische Feldeffekttransistoren als Pixel-Steuerelemente in Aktiv- Matrix-Bildschirmen oder für die Herstellung von extrem preiswerten integrierten Schaltungen, wie sie zum Beispiel für die aktive Kennzeichnung und Identifizierung von Waren und Gütern zum Einsatz kommen, aber auch für zukünftige Steuerschaltungen organischer Speicherelemente.

Transistoren und integrierte Schaltungen (ICs) basierend auf organischen Halbleiterschichten arbeiten heute weitestgehend auf p-MOS Technologie, da im Wesentlichen nur organische p-Halbleiter stabil genug sind um langlebige Devices herzustellen.

Die meisten bisher bekannten organischen Halbleiter (z.B. Pentazen, Tetrazen, Oligo- und Polythiophene), die auch von ihrer Ladungsträgerbeweglichkeit für Anwendungen in Betracht kommen, weisen in Transistoren meist eine leicht positive Schwellspannung auf d.h. die Transistoren schalten bei einem Potential von 0 V an der Gateelektrode noch nicht vollständig aus. Dies hat zur Konsequenz, dass einfache Inverter (zwei Transistoren) nicht die korrekte logische Funktion zeigen und darauf basierte Ringoszillatoren nicht oszillieren.

Bisher wird dieses Problem schaltungstechnisch in der Weise gelöst, dass Inverter und daraus resultierende Schaltungen mit einem integrierten "Levelshift" hergestellt werden. Diese zusätzliche "Korrektur" der logischen Funktion hat zur Konsequenz, dass sich die Anzahl der Transistoren für einen funktionsfähigen Inverter von zwei auf vier verdoppelt (H. Klauk, D.J. Gundlach, T.N. Jackson IEEE Electron Device Letters, 1999, 20, 289-291).

Zudem wird eine weitere Versorgungsspannung für den Levelshifter benötigt.

Des Weiteren existieren Ansätze durch die Wahl eines geeigneten Gatedielektrikums (anorganisch oder organisch) die Schwellspannung einzustellen (siehe H. Klauk, M. Halik, U. Zschieschang, G. Schmid, W. Radlik, W. Weber Journal of Applied Physics, 2002, 92, 5259-5263). Dabei zeigte sich jedoch, dass Werte im negativen Bereich (ca. -8V) erreicht wurden, die Schwankungen dieser Werte jedoch relativ groß sind (+/- 10V) und damit derzeit kein zuverlässiges Schaltungsdesign für ICs möglich ist. Auch ist zwar beschrieben dass eine Monolage von Octadecyltrichlorosilane (OTS) im Fall von SiO₂ als Gatedielektrikum in Pentazentransistoren eine Verschiebung der Schwellspannung verglichen mit blanken SiO₂ als Gatedielektrikum um wenige Volt bewirkt, jedoch nicht in der Weise, dass eine systematische und vor allem definierte Einstellung der Schwellspannung vorgenommen werden kann.

Eine dritte Möglichkeit besteht im dynamischen Betrieb einer Schaltung. Dabei wird ein Schaltungssystem durch Anlegen einer externen Impulsspannung aktiviert (W. Fix, A. Ullmann, J. Ficker, W. Clemens Applied Physics Letters, 2002, 81, 1735-1737). Dies ist für einfache Demonstratorschaltungen prinzipiell möglich, jedoch für komplexere logische Schaltungen sehr aufwändig.

Aufgabe dieser Erfindung ist es, die OFETs in der Weise zu modifizieren, so dass die zusätzliche Korrektur der logischen Funktion (levelshift) überflüssig wird.

Diese Aufgabe wird erfindungsgemäß durch ein Halbleiterbauelement mit den Merkmalen des Anspruchs 1 gelöst.

Das erfindungsgemäße Halbleiterbauelement weist eine Schicht mit einer Verbindung auf, die mindestens eine Ankergruppe zur Herstellung einer Bindung mit einem Substrat und mindestens eine Gruppe mit mindestens einem freien Elektronenpaar und / oder einem Dipolmoment aufweist. Die Ankergruppe ist notwendig, damit sich eine ortsfeste Schicht ausbilden kann.

Der erfindungsgemäße Effekt beruht darauf, dass die eingebrachte Verbindung zum einen Ladungsträgersenken (Traps) schließt und gleichzeitig durch deren hohe Ordnung die molekularen Eigenschaften der Moleküle (Dipolmoment) einen makroskopische Effekt ausbildet, der die elektrochemischen und elektrischen Eigenschaften einer z.B. darüber liegenden organischen Halbleiterschicht und die Morphologie günstig beeinflusst.

Dies hat die Wirkung, dass sich die Zahl der Transistoren für eine logische Schaltung nahezu halbieren würde, somit auch weniger Interconnects und Vias benötigt würden und daraus folgend die benötigte Fläche für die Schaltung kleiner würde. Des Weiteren sollte sich die Ausbeute erhöhen. Die zweite Versorgungsspannung für den Levelshifter entfällt ebenfalls. Diese Modifikation erfolgt auf chemischem Wege in der Weise, dass in den Kanal des Transistors (Strecke auf dem Dielektrikum zwischen Source und Drain Elektrode) vor Abscheiden des organischen Halbleiters eine chemische Verbindung ein-/aufgebracht wird, welche die elektrischen Eigenschaften des organischen Halbleiters bei Anlegen einer Spannung beeinflusst.

In einer vorteilhaften Ausgestaltung ist mindestens eine Ankergruppe kovalent an eine dielektrische Schicht bindbar. Besonders vorteilhaft ist es, wenn mindestens eine Ankergruppe eine Silizium-Halogen-Gruppe, eine Silizium-Alkoxy-Gruppe, eine Aminogruppe, eine Amidgruppe oder ein reaktives Carbonsäurederivat, insbesondere ein Chlorid oder ein Orthoester ist.

In einer weiteren vorteilhaften Ausgestaltung weist die Gruppe zur Erzeugung eines Dipolmomentes eine polare Gruppe, insbesondere eine Aminogruppe, eine Cyanogruppe, eine Nitrogruppe oder eine Ferrocenylgruppe auf. Ferner ist es vorteilhaft, wenn die Gruppe mit einem freien Elektronenpaar Sauerstoff, Stickstoff, Schwefel und / oder Phosphor aufweist.

Wenn die Verbindung die Fähigkeit zur Bildung monomolekularer Schichten auf dem Substrat, insbesondere einer dielektrischen Schicht aufweist, lassen sich Halbleiterbauelemente in einfacher Weise aus Schichten aufbauen.

Die Bildung von Monolagen wir insbesondere erleichtert, wenn die Verbindung im Wesentlichen linear ausgebildet ist oder eine im Vergleich zu anderen Gruppen der Verbindung lange Achse aufweist. Auch ist es insbesondere für Monolagen vorteilhaft, wenn die Ankergruppe und die Gruppe mit dem Dipolmoment oder die Gruppe mit einem freien Elektronenpaar an gegenüber liegenden Enden der linearen Verbindung angeordnet sind. Besonders vorteilhaft ist es, wenn ein Teil der Verbindung eine erhöhte Affinität zur Oberfläche des Substrates, insbesondere einer dielektrischen Schicht, aufweist, und dass am entgegengesetzten Ende der Verbindung eine Gruppe mit hoher Packungsdichte angeordnet ist, die inert zum Substrat ist.

Besonders gezielt lässt sich die Schwellspannung unterdrücken, wenn die Verbindung eine der folgenden Strukturen aufweist:

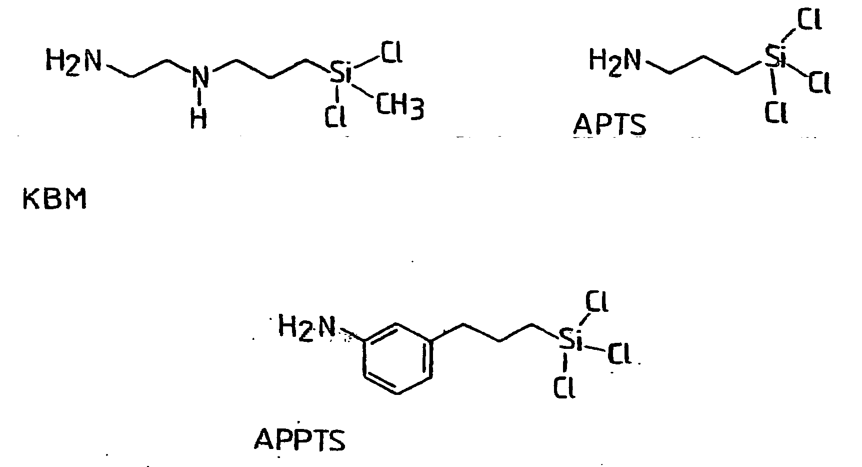

Auch ist es vorteilhaft, wenn die Verbindung ein Polyvinylpyrrolidon, ein Pyridilinon oder statistische oder Block-Kopolymere, die diese Einheiten enthalten, ist.

Die Aufgabe wird auch durch ein Verfahren zur Herstellung des Halbleiterbauelementes mit dem Merkmalen des Anspruchs 12 gelöst.

Dabei wird ein Substrat, insbesondere ein Bauelementsubstrat mit einer dielektrischen Schicht, in eine Lösung getaucht oder aus einer Gasphase abgeschieden, wobei die Lösung oder die Gasphase mindestens eine der Verbindungen gemäß Anspruch 1 bis 11 enthält.

Die chemische Verbindung soll hierbei möglichst dünn, bevorzugt als Monolage, und preiswert aufgebracht werden. Sie soll im Kanal möglichst chemisch fixiert sein (kovalent gebunden an das Dielektrikum) um Diffusionsprozesse zu vermeiden. Durch die Art der chemischen Verbindung sollte sich der Wert für die Schwellspannung justieren lassen, um ein optimalen/einstellbaren Wert der Schwellspannung bei der jeweiligen Anwendung zu erhalten.

Für den Fall der Abscheidung aus der Lösung ist es vorteilhaft, wenn Konzentration der Verbindung in der Lösung zwischen 0,1 und 1% beträgt.

Vorteilhafterweise lässt sich ein Halbleiterbauelement, insbesondere ein OFET, herstellen, wenn nach dem Aufbringen der Schicht mit der Verbindung nach mindestens einem der Ansprüche 1 bis 11 eine Source-Drain Schicht und eine organische Halbleiterschicht aufgebracht wird.

Die Erfindung wird nachfolgend unter Bezugnahme auf die Figuren der Zeichnungen an mehreren Ausführungsbeispielen näher erläutert. Es zeigen:
- Fig. 1: eine schematische Schnittansicht durch einen organischen Feldeffekttransistor;
- Fig. 2: eine schematische Darstellung einer Schichtenstruktur mit einer Schicht mit einer erfindungsgemäßen Verbindung;
- Fig. 3a-c: Strukturformeln von Ausführungsformen der erfindungsgemäßen Verbindung;
- Fig. 4a: Messergebnis der Schwellspannung in Abhängigkeit der ausgewählten Verbindung;
- Fig. 4b: Korrelation der gemessenen Schwellspannung mit dem Dipolmoment;
- Tab. 1: Schwellspannung bei OFET mit unterschiedlichen Substanzen.

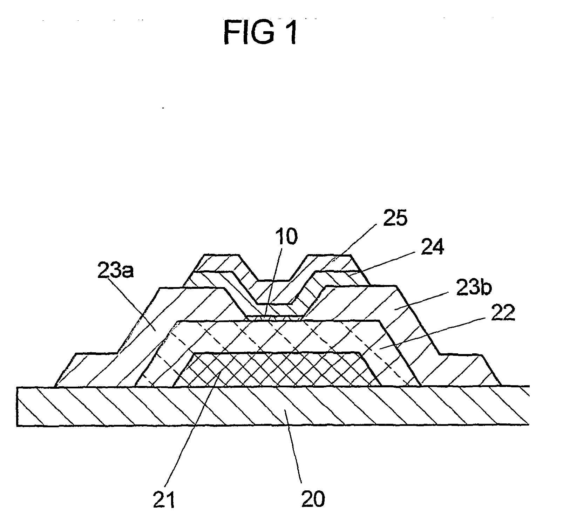

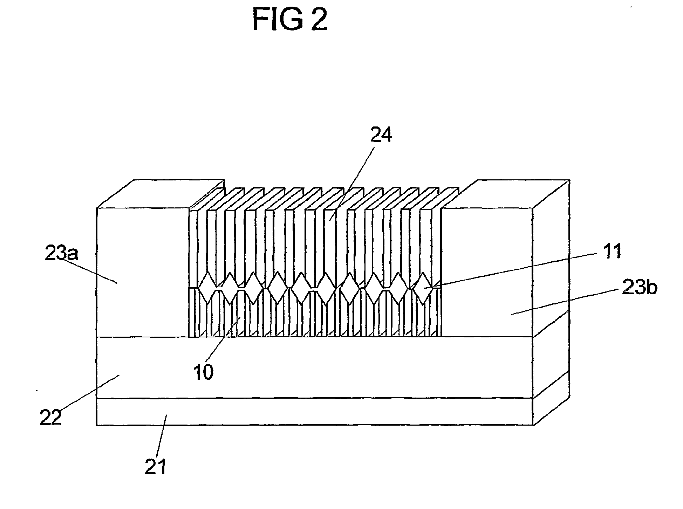

Bevor auf Ausführungsbeispiele für die erfindungsgemäßen Halbleiterbauelemente eingegangen wird, soll anhand der Fig. 1 und 2 der Aufbau eines organischen Feldeffekttransistors als Halbleiterbauelement erläutert werden.

Fig. 1 zeigt dabei eine schematische Schnittansicht durch einen organischen Feldeffekttransistor (OFET).

Organische Feldeffekttransistoren sind elektronische Bauteile, die aus mehreren Schichten (Lagen) bestehen, welche alle strukturiert sind, um durch Verbindungen einzelner Schichten integrierte Schaltungen zu generieren. Dabei zeigt Fig. 1 den prinzipiellen Aufbau eines solchen Transistors in einer Bottom-Kontakt Architektur.

Auf einem Basis-Substrat 20 ist eine Gateelektrode 21 angeordnet, die von einer Gatedielektrikumsschicht 22 überdeckt ist. Derartige Dielektrika besitzen eine Schichtdicke von weniger als 5 nm (Bottom up).

Auf der Gatedielektrikumsschicht 22 ist in einem Bereich eine Schicht zur Einstellung der Schwellspannung 10 angeordnet; die Gatedielektrikumsschicht 22 bildet damit das Substrat für die Schicht zur Einstellung der Schwellspannung 10. Diese Schicht zur Einstellung der Schwellspannung 10 steht nach oben hin mit einer aktiven halbleitenden Schicht 24 (hier mit Pentazen) in Verbindung. Seitlich sind eine Sourceschicht 23a und eine Drainschicht 23b angeordnet, die beide ebenfalls mit der darbüberliegenden aktiven halbleitenden Schicht 24 in Verbindung stehen. Über der aktiven Schicht 24 ist eine Passivierungsschicht 25 angeordnet.

In Fig. 2 ist der Bereich des Ladungsträgerkanals im OFET gemäß Fig. 1 vergrößert dargestellt. Die Rauten 11 sollen die elektrostatischen Wechselwirkungen zwischen der Schicht zur Einstellung der Schwellspannung 10 und der darüber liegenden aktiven Schicht 25 symbolisieren.

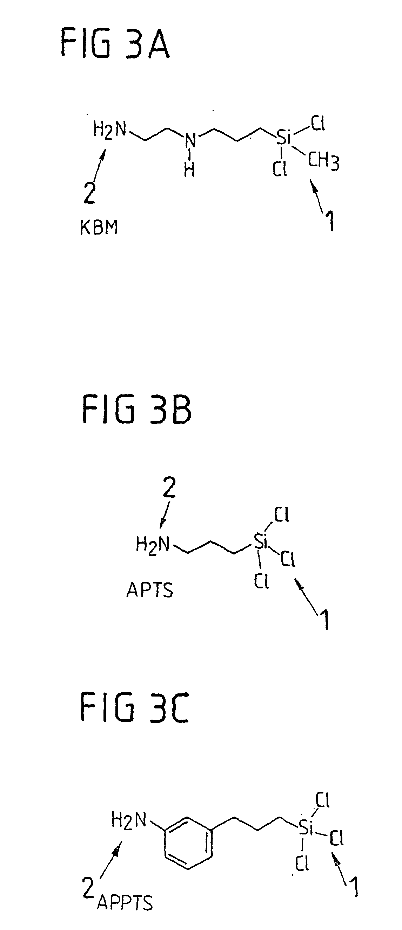

In den Fig. 3a bis 3c sind drei Ausführungsformen der erfindungsgemäßen Verbindungen dargestellt. Alle drei Verbindungen KBM, APTS und APPTS weisen eine Ankergruppe 1 auf, die als eine Silangruppe ausgebildet ist. Mit dieser Ankergruppe 1 kann die Verbindung eine Bindung mit einem Substrat, wie z.B. der Dielektrikumsschicht 22 in Fig. 2 eingehen. Aufgrund des im Wesentlichen linearen Charakters der drei Verbindungen können sich Monolagen ausbilden, bei denen die Längsachsen der Verbindung jeweils parallel zueinander und senkrecht zur Dielektrikumsschicht 22 ausgerichtet sind. Alle drei Verbindungen weisen darüber hinaus polare Gruppen 2 an den Enden der Verbindung auf, die der Ankergruppe 1 entgegengesetzt ist.

Eine Monolage 10 aus einer dieser Verbindungen gemäß Fig. 2 wirkt in der Weise, dass sie in elektrischer Wechselwirkung mit einer darüber liegenden Halbleiterschicht 24 (z.B. Pentazen) tritt und dabei die halbleitenden Eigenschaften so ändert, dass die Schwellspannung gezielt beeinflussbar ist, insbesondere dass sie gesenkt wird.

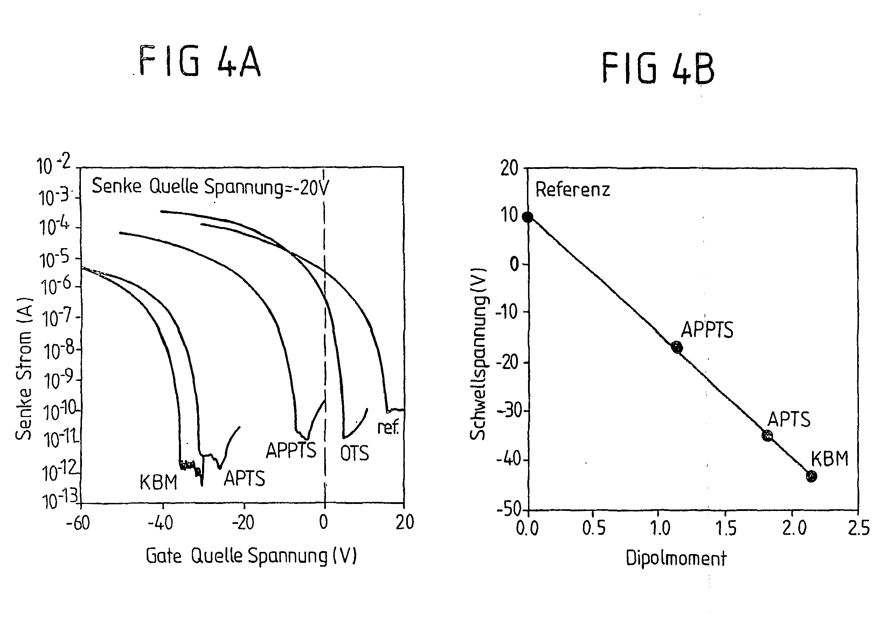

Dies wird in Zusammenhang mit den Fig. 4a und 4 und Tab. 1 noch erläutert werden.

Der Vorteil einer solchen Schicht 10 mit erfindungsgemäßen Verbindungen (z.B. gemäß Fig. 3) ist, dass sie sich preiswert auf die Transistorstruktur (vor Abscheidung der organischen Halbleiterschicht) aufbringen lässt.

Das Verfahren hierfür kann ein einfacher Tauchprozess sein, bei dem das Substrat in eine verdünnte Lösung (Lösungsmittel mit ca. 0.1 -1 % Substanz) getaucht wird. Hierbei binden sich die Moleküle mittels ihrer Ankergruppe 1 an die dielektrische Schicht 22. Beispielsweise bindet ein Chloro- oder Alkoxysilan selektiv an eine mit OH-Gruppen funktionialisierte Oberfläche unter Ausbildung einer Si-O-Bindung. Das überschüssige Material wird dann mit reinem Lösungsmittel abgewaschen.

Alternativ ist auch eine Gasphasendeposition möglich. Die in Fig. 3a bis 3c dargestellten Verbindungen werden dabei jeweils als Monolage aus der Gasphase auf hochdotierte thermisch oxidierte (100 nm SiO₂) Siliziumwafer aufgebracht. Anschließend wird eine 30 nm dicke Schicht 24 Pentazen (organischer Halbleiter) aufgedampft. Zur Vervollständigung des Transistoraufbaus werden Source- und Drain-Kontakte (23a, 23b) durch Aufdampfen einer 30 nm dicken Goldschicht (Strukturierung erfolgt durch Auflage einer Schattenmaske) definiert. Im Anschluss werden die Transistoren elektrisch charakterisiert.

Zu Vergleichszwecken werden als Referenz ein OFET in der gleichen Weise ohne eine solche Monolage hergestellt und durchgemessen. Auch eine Beschichtung mit OTS erfolgte zu Vergleichszwecken.

Die Ergebnisse der gemessenen Schwellspannungen sind in Tabelle 1 und Fig. 4a dargestellt. Die Korrelation der gemessenen Schwellspannungen mit dem Dipolmoment der jeweiligen Verbindung ist in Fig. 4b gezeigt. Dabei zeigt sich deutlich, dass die Schwellspannung in Abhängigkeit von den Verbindungen gezielt einstellbar ist. Dabei korrelieren die Schwellspannungen mit Moleküleigenschaften (wie z.B. Dipolmoment) und Schichteigenschaften (wie z.B. der freien Oberflächenenergie). Deutlich erkennbar ist, dass die Schwellspannung gegenüber der Referenz (keine gesonderte Schicht) und auch gegenüber OTS deutlich verringert ist.

Der Hauptvorteil dieser Erfindung besteht darin, dass ein solcher hier beschriebener einfacher Prozess der chemischen Modifikation der Dielektrikumsoberfläche und somit des Ladungsträgerkanals, die bisher nötige Lösung des Problems der positiven Schwellspannungen in OFETs mittels Levelshift komplett überflüssig macht und somit ca. 50 Prozent der benötigten Transistoren pro Schaltung einspart.

**Tabelle 1**

| SAM - Material | Vₜₕ [V] |
|---|---|
| kein SAM (reference) | 2 |
| OTS | -1 |
| APPTS | -17 |
| APTS | -35 |
| KBM | -43 |

### Bezugszeichenliste

- 1: Ankergruppe
- 2: polare Gruppe

- 10: Schicht zur gezielten Einstellung der Schwellspannung mittels elektrostatischer Wechselwirkung

- 20: Basis-Substrat für OFET
- 21: Gateelektrode
- 22: Gatedielektrikumsschicht
- 23a: Sourceschicht
- 23b: Drainschicht
- 24: aktive Halbleiterschicht
- 25: Passivierungsschicht

## Patentansprüche

1. Halbleiterbauelement umfassend ein Basis-Substrat, eine Gate-Elektrode, eine Gatedielektrikumsschicht, eine Source-Elektrode, eine Drain-Elektrode, eine Halbleiterschicht, und eine Passivierungsschicht
**gekennzeichnet durch**
mindestens einen **durch** Source-Elektrode (23a), Drain-Elektrode (23b), Dielektrikumsschicht (22) und Halbleiterschicht (24) begrenzten Kanal, wobei in dem Kanalauf der Dielektrikumsschicht (22) eine Schicht (10) zur Steuerung einer elektrostatischen Wechselwirkung zwischen der Dielektrikumsschicht (22) und der Halbleiterschicht (24) angeordnet ist, und wobei die Schicht (10) mindestens eine Verbindung mit
a) mindestens einer Ankergruppe (1) zur Herstellung einer Bindung mit der Dielektrikumsschicht (22), und
b) mindestens einer Gruppe (2) mit mindestens einem freien Elektronenpaar und / oder einem Dipolmoment aufweist.

2. Halbleiterbauelement, nach Anspruch 1, **dadurch gekennzeichnet, dass** es als ein organischer Feldeffekttransistor ausgebildet ist.

3. Halbleiterbauelement nach Anspruch 1 oder 2, **dadurch gekennzeichnet, dass** mindestens eine Ankergruppe (1) kovalent an eine dielektrische Schicht bindbar ist.

4. Halbleiterbauelement nach mindestens einem der vorhergehenden Ansprüche, **dadurch gekennzeichnet, dass** mindestens eine Ankergruppe (1) eine Silizium-Halogen-Gruppe, eine Silizium-Alkoxy-Gruppe, eine Aminogruppe, eine Amidgruppe oder ein reaktives Carbonsäurederivat, insbesondere ein Chlorid oder ein Orthoester ist.

5. Halbleiterbauelement nach mindestens einem der vorhergehenden Ansprüche, **dadurch gekennzeichnet, dass** die Gruppe zur Erzeugung eines Dipolmomentes ein polare Gruppe, insbesondere eine Aminogruppe, eine Cyanogruppe, eine Nitrogruppe oder eine Ferrocenylgruppe aufweist.

6. Halbleiterbauelement nach mindestens einem der vorhergehenden Ansprüche, **dadurch gekennzeichnet, dass** die Gruppe mit mindestens einem freien Elektronenpaar Sauerstoff, Stickstoff, Schwefel und / oder Phosphor aufweist.

7. Halbleiterbauelement nach mindestens einem der vorhergehenden Ansprüche, **dadurch gekennzeichnet, dass** die Verbindung die Fähigkeit zur Bildung monomolekularer Schichten auf dem Substrat (22), insbesondere einer dielektrischen Schicht, aufweist.

8. Halbleiterbauelement nach mindestens einem der vorhergehenden Ansprüche, **dadurch gekennzeichnet, dass** die Verbindung im Wesentlichen linear ausgebildet ist oder eine im Vergleich zu anderen Gruppen der Verbindung lange Achse aufweist.

9. Halbleiterbauelement nach Anspruch 8, **dadurch gekennzeichnet, dass** die Ankergruppe (1) und die Gruppe mit dem Dipolmoment (2) oder die Gruppe mit einem freien Elektronenpaar an gegenüber liegenden Enden der linearen Verbindung angeordnet sind.

10. Halbleiterbauelement nach Anspruch 8 oder 9, **dadurch gekennzeichnet, dass** ein Teil der Verbindung eine erhöhte Affinität zur Oberfläche des Substrates (22), insbesondere einer dielektrischen Schicht, aufweist, und dass am entgegengesetzten Ende der Verbindung eine Gruppe mit hoher Packungsdichte angeordnet ist, die inert zum Substrat (22) ist.

11. Halbleiterbauelement nach mindestens einem der vorhergehenden Ansprüche, **dadurch gekennzeichnet, dass** die Verbindung eine der folgenden Strukturen aufweist:

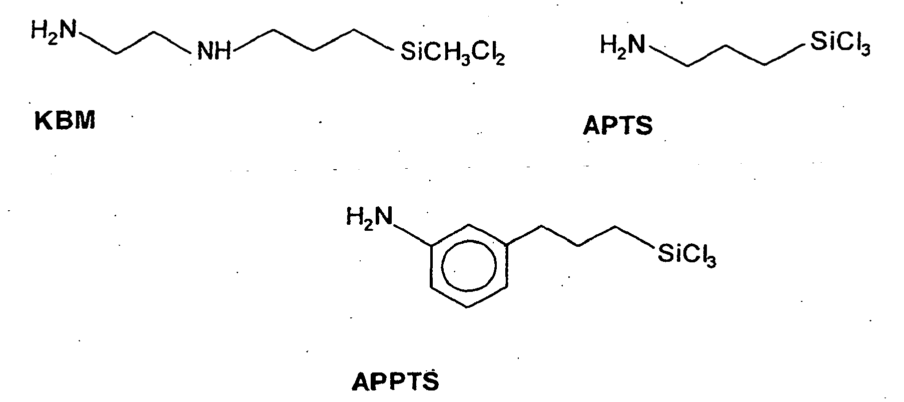

12. Halbleiterbauelement nach mindestens einem der vorhergehenden Ansprüche, **dadurch gekennzeichnet, dass** die Verbindung ein Polyvinylpyrrolidon, ein Pyridilinon oder statistische oder Block-Kopolymere, die diese Einheiten enthalten, ist.

13. Verfahren zur Herstellung einer Schichtstruktur in einem Halbleiterbauelement nach mindestens einem der Ansprüche 1 bis 11
**dadurch gekennzeichnet, dass**
ein Substrat, insbesondere ein Bauelementsubstrat (20) mit einer dielektrischen Schicht (22) in eine Lösung getaucht wird oder aus einer Gasphase abgeschieden wird, die mindestens eine der Verbindungen gemäß Anspruch 1 bis 11 enthält.

14. Verfahren nach Anspruch 12, **dadurch gekennzeichnet, dass** die Konzentration der Verbindung in der Lösung zwischen 0,1 und 1% beträgt.

15. Verfahren nach Anspruch 13 oder 14, **dadurch gekennzeichnet, dass** nach dem Aufbringen der Schicht mit der Verbindung (10) nach mindestens einem der Ansprüche 1 bis 11 eine Source-Drain Schicht (23a, 23b) und eine organische Halbleiterschicht (24) aufgebracht wird.

## Claims

1. Semiconductor component comprising a base substrate, a gate electrode, a gate dielectric layer, a source electrode, a drain electrode, a semiconductor layer and a passivation layer,
**characterized by**
at least one channel delimited by source electrode (23a), drain electrode (23b), dielectric layer (22) and semiconductor layer (24), a layer (10) for controlling an electrostatic interaction between the dielectric layer (22) and the semiconductor layer (24) being arranged in the channel on the dielectric layer (22), and the layer (10) having at least one compound comprising
a) at least one anchor group (1) for producing a bond with the dielectric layer (22), and
b) at least one group (2) having at least one free pair of electrons and/or a dipole moment.

2. Semiconductor component according to Claim 1, **characterized in that** it is formed as an organic field effect transistor.

3. Semiconductor component according to Claim 1 or 2, **characterized in that** at least one anchor group (1) can be covalently bonded to a dielectric layer.

4. Semiconductor component according to at least one of the preceding claims, **characterized in that** at least one anchor group (1) is a silicon-halogen group, a silicon-alkoxy group, an amino group, an amide group or a reactive carboxylic acid derivative, in particular a chloride or an ortho ester.

5. Semiconductor component according to at least one of the preceding claims, **characterized in that** the group for producing a dipole moment has a polar group, in particular an amino group, a cyano group, a nitro group or a ferrocenyl group.

6. Semiconductor component according to at least one of the preceding claims, **characterized in that** the group having at least one free pair of electrons has oxygen, nitrogen, sulfur and/or phosphorus.

7. Semiconductor component according to at least one of the preceding claims, **characterized in that** the compound has the ability to form monomolecular layers on the substrate (22), in particular a dielectric layer.

8. Semiconductor component according to at least one of the preceding claims, **characterized in that** the compound is formed essentially in linear fashion or has a long axis in comparison with other groups of the compound.

9. Semiconductor component according to Claim 8, **characterized in that** the anchor group (1) and the group having the dipole moment (2) or the group having a free pair of electrons are arranged at opposite ends of the linear compound.

10. Semiconductor component according to Claim 8 or 9, **characterized in that** a part of the compound has an increased affinity for the surface of the substrate (22), in particular a dielectric layer, and **in that** there is arranged at the opposite end of the compound a group with high packing density, which is inert with respect to the substrate (22).

11. Semiconductor component according to at least one of the preceding claims, **characterized in that** the compound has one of the following structures:

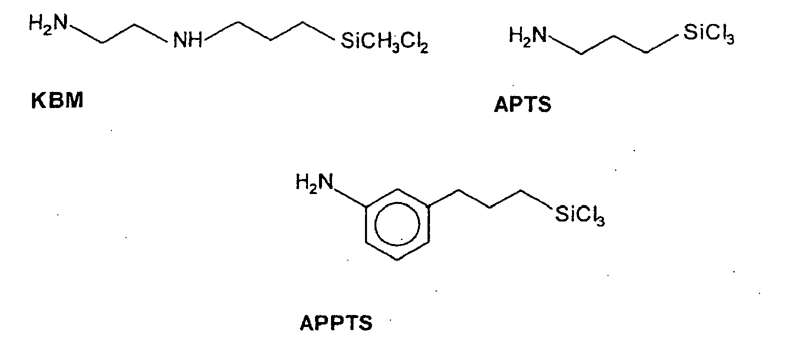

12. Semiconductor component according to at least one of the preceding claims, **characterized in that** the compound is a polyvinylpyrrolidone, a pyridilinone or statistical or block copolymers which contain these units.

13. Method for the production of a layer structure in a semiconductor component according to at least one of Claims 1 to 11,
**characterized in that**
a substrate, in particular a component substrate (20) with a dielectric layer (22), is dipped into a solution or is deposited from a vapor phase which contains at least one of the compounds in accordance with Claims 1 to 11.

14. Method according to Claim 12, **characterized in that** the concentration of the compound in the solution is between 0.1 and 1%.

15. Method according to Claim 13 or 14, **characterized in that** after the application of the layer having the compound (10) according to at least one of Claims 1 to 11, a source-drain layer (23a, 23b) and an organic semiconductor layer (24) are applied.

## Revendications

1. Composant semi-conducteur, comprenant un substrat de base, une électrode de grille, une couche diélectrique de grille, une électrode de source, une électrode drain (collectrice), une couche de semi-conducteur, et une couche de passivation
**caractérisé par**
au moins un canal limité par une électrode de source (23a), une électrode drain (23b), une couche de diélectrique (22) et une couche de semi-conducteur (24), dans le canal étant disposée sur la couche de diélectrique (22) une couche (10) pour la commande d'une interaction électrostatique entre la couche de diélectrique (22) et la couche de semi-conducteur (24), et la couche (10) comportant au moins un composé comportant
a) au moins un groupe d'ancrage (1) pour la production d'une liaison avec la couche de diélectrique (22) et
b) au moins un groupe (2) présentant au moins une paire d'électrons libres et/ou un moment dipolaire.

2. Composant semi-conducteur selon la revendication 1, **caractérisé en ce qu'**il est constitué en tant qu'un transistor à effet de champ.

3. Composant semi-conducteur selon la revendication 1 ou 2, **caractérisé en ce qu'**au moins un groupe d'ancrage (1) est apte à se lier par covalence à une couche diélectrique.

4. Composant semi-conducteur selon au moins l'une des revendications précédentes, **caractérisé en ce qu'**au moins un groupe d'ancrage (1) est un groupe silicium-halogène, un groupe silicium-alcoxy, un groupe amino, un groupe amido ou un dérivé d'acide carboxylique réactif, en particulier un chlorure ou un orthoester.

5. Composant semi-conducteur selon au moins l'une des revendications précédentes, **caractérisé en ce que** le groupe pour la production d'un moment dipolaire comporte un groupe polaire, en particulier un groupe amino, un groupe cyano, un groupe nitro ou un groupe ferrocényle.

6. Composant semi-conducteur selon au moins l'une des revendications précédentes, **caractérisé en ce que** le groupe comportant au moins une paire d'électrons libres comporte un atome d'oxygène, d'azote, de soufre et/ou de phosphore.

7. Composant semi-conducteur selon au moins l'une des revendications précédentes, **caractérisé en ce que** le composé a l'aptitude à la formation de couches monomoléculaires sur le substrat (22), en particulier d'une couche diélectrique.

8. Composant semi-conducteur selon au moins l'une des revendications précédentes, **caractérisé en ce que** le composé a essentiellement une structure linéaire ou présente un axe long par comparaison avec les autres groupes du composé.

9. Composant semi-conducteur selon la revendication 8, **caractérisé en ce que** le groupe d'ancrage (1) et le groupe présentant le moment dipolaire (2) ou le groupe comportant une paire d'électrons libres sont disposés aux extrémités opposées du composé linéaire.

10. Composant semi-conducteur selon la revendication 8 ou 9, **caractérisé en ce qu'**une partie du composé présente une affinité accrue pour la surface du substrat (22), en particulier pour une couche diélectrique, et **en ce qu'**à l'extrémité opposée du composé est disposé un groupe à haut degré de tassement, qui est inerte par rapport au substrat (22).

11. Composant semi-conducteur selon au moins l'une des revendications précédentes, **caractérisé en ce que** le composé présente l'une des structures suivantes :

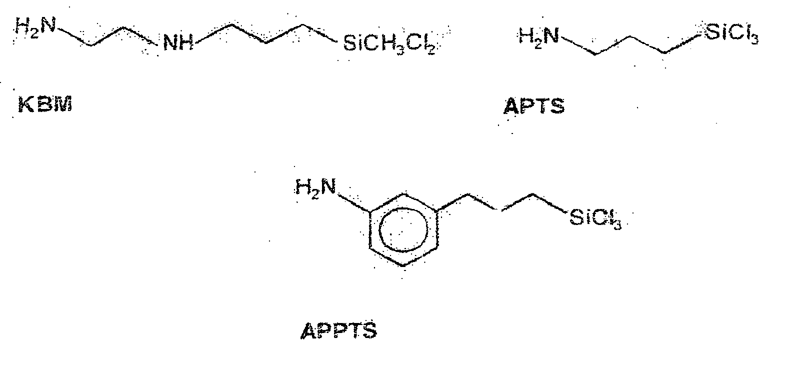

12. Composant semi-conducteur selon au moins l'une des revendications précédentes, **caractérisé en ce que** le composé est une polyvinylpyrrolidone, une pyridilinone ou des copolymères statistiques ou séquencés qui contiennent ces motifs.

13. Procédé pour la production d'une structure stratifiée dans un composant semi-conducteur selon au moins l'une des revendications 1 à 11, **caractérisé en ce qu'**un substrat, en particulier un substrat (20) de composant comportant une couche diélectrique (22) est immergé dans une solution ou est déposé à partir d'une phase gazeuse, qui contient au moins un des composés selon l'une quelconque des revendications 1 à 11.

14. Procédé selon la revendication 12, **caractérisé en ce que** la concentration du composé dans la solution est comprise entre 0,1 et 1 %.

15. Procédé selon la revendication 13 ou 14, **caractérisé en ce qu'**après l'application de la couche comportant le composé (10) selon au moins l'une des revendications 1 à 11, une couche de drain-source (23a, 23b) et une couche de semi-conducteur (24) ont appliquées.
